# EUROPEAN PATENT SPECIFICATION

(11) **EP 3 091 659 B1**
(45) Date of publication and mention of the grant of the patent: **30.03.2022**
(21) Application number: 15197508.3
(22) Date of filing: 02.12.2015
(51) Int. Cl.: H03F 3/217

(54) **HIGH EFFICIENCY CLASS D AMPLIFIER WITH REDUCED GENERATION OF EMI**
HOCHEFFIZIENTER KLASSE-D-VERSTÄRKER MIT VERMINDERTER ERZEUGUNG VON ELEKTROMAGNETISCHEN STÖRUNGEN
AMPLIFICATEUR DE CLASSE D À HAUTE EFFICACITÉ AVEC PRODUCTION RÉDUITE D'EMI

(30) Priority: 08.05.2015 CN 201510234028; 19.05.2015 US 201514715879
(43) Date of publication of application: 09.11.2016
(73) Proprietor: STMicroelectronics (Shenzhen) R&D Co. Ltd, Nanshan, Shenzhen 518057 (CN)
(72) Inventor: LIU, QiYu, Nanshan, Shenzhen 518057 Guangdong Province (CN); LIN, Hong Wu, 518057 Shenzhen, Nanshan (CN)
(74) Representative: Smith, Gary John

(56) References cited:
- EP-A1- 1 594 223
- US-A1- 2004 232 979

## Description

### TECHNICAL FIELD

This disclosure is related to the field of class D audio amplifiers, and, more particularly, to a class D amplifier design with reduced EMI as compared to conventional class D amplifiers.

### BACKGROUND

Portable electronic devices, such as smartphones and tablets are popular with consumers. Such portable electronic devices are capable of audio playback, and thus employ audio amplifiers. Since these portable electronic devices are powered by batteries, reduction of power consumption is a commercial desire, and thus class D audio amplifiers, which are more efficient than class AB audio amplifiers, may potentially be useful for incorporation into these electronic devices.

A class D amplifier is an electronic amplifier in which the amplifying devices (typically MOSFETs) operate as electronic switches, instead of as linear gain devices as in other amplifiers. The analog signal to be amplified is converted to a series of square pulses before being applied to the amplifying devices. Since the signal to be amplified is a train of constant amplitude pulses, the amplifying devices switch rapidly back and forth between conductive and nonconductive states. After amplification, the output pulse train can be converted back to an analog signal by passing it through a passive low pass filter.

As stated, an advantage of a class D amplifier is that it can be more efficient than other amplifiers, since less power is dissipated as heat in the active devices. However, the switching of the active devices results in increased EMI, which is particularly undesirable in smartphones and tablets. As such, improved class D amplifier designs which reduce EMI are commercially desirable.

EP1594223A1 discloses a class D amplifier which comprises a voltage control current source circuit for current-converting the voice voltage signal Vsin of the input into two signals with different polarities, two capacitance elements for integration where the electric charges of the each current-converted signal and the feedback signal are stored respectively, two hysteresis comparators for PWM conversion for comparing the potentials of the two capacitance elements for integration and a reference potential Vcom respectively, two output buffers for amplifying the outputs thereof respectively, and two constant current source feedback circuits for feeding back the output thereof respectively.

US 2004/232979 A1 discloses a method and apparatus to enable the use of class D amplifiers without the need for an output filter, while maintaining both a high efficiency and a high audio fidelity.

### SUMMARY

The invention is defined by the independent claims. Preferred embodiments are set out in the dependent claims.

This summary is provided to introduce a selection of concepts that are further described below in the detailed description. This summary is not intended to identify key or essential features of the claimed subject matter, nor is it intended to be used as an aid in limiting the scope of the claimed subject matter.

An electronic device in accordance with this disclosure includes first and second comparators configured to respectively convert first and second analog audio input signals into first and second audio square waves. A logic block is coupled to receive the first and second audio square waves from the first and second comparators. The logic block is configured to generate a first processed audio signal representing a difference between the first audio square wave and the second audio square wave when a duty cycle of the first audio square wave is greater than a duty cycle of the second audio square wave, generate the first processed audio signal having a reference DC level when the duty cycle of the first audio square wave is less than the duty cycle of the second audio square wave, generate a second processed audio signal representing a difference between the second audio square wave and the first audio square wave when the duty cycle of the second audio square wave is greater than the duty cycle of the first audio square wave, and generate the second processed audio signal having the reference DC level when the duty cycle of the second audio square wave is less than the duty cycle of the first audio square wave. First and second output stages are coupled to the logic block and configured to generate first and second audio output signals respectively based upon the first and second processed audio signals. The first comparator may be configured to convert the first analog audio input signal into a first audio square wave by comparing the first analog audio input signal to a triangle wave. The second comparator may be configured to convert the second analog audio input signal into a second audio square wave by comparing the second analog audio input signal to a triangle wave. The first comparator may be configured to convert the first analog audio input signal into a first audio square wave by comparing the first analog audio input signal to a sawtooth wave. The second comparator may be configured to convert the second analog audio input signal into a second audio square wave by comparing the second analog audio input signal to the sawtooth wave. The logic block may comprise: first and second inverters to configured receive the first and second audio square waves and to output inverted versions of the first and second audio square waves; a first AND gate configured to generate the first processed audio signal as having a first logic level based upon the first audio square wave and the inverted version of the second audio square wave having the first logic level; and a second AND gate configured to generate the second processed audio signal as having a first logic level based upon the second audio square wave and the inverted version of the first audio square wave having the first logic level. The first output stage may comprise: a first amplifier configured to receive the first processed audio signal and to generate a first amplified audio signal, a first PMOS transistor having a source coupled to a supply voltage, a drain, and a gate to receive the first amplified audio signal, and a first NMOS transistor having a source coupled to ground, a drain coupled to the drain of the first PMOS transistor, and a gate to receive the first amplified audio signal, wherein the first PMOS transistor and first NMOS transistor may cooperate to generate the first audio output signal. The second output stage may comprise: a second amplifier configured to receive the second processed audio signal and to generate a second amplified audio signal, a second PMOS transistor having a source coupled to a supply voltage, a drain, and a gate to receive the second amplified audio signal, and a second NMOS transistor having a source coupled to ground, a drain coupled to the drain of the second PMOS transistor, and a gate to receive the second amplified audio signal, wherein the second PMOS transistor and second NMOS transistor may cooperate to generate the second audio output signal. The electronic device may further comprise a load coupled to receive the first and second audio output signals. The second analog audio input signal may be an inverse of the first analog audio input signal. The first and second analog audio input signals may be differential signals. The embodiment is directed to a class D amplifier that includes a signal processing block configured to generate a first processed signal representing a difference between a first differential signal and a second differential signal when a duty cycle of the first differential signal is greater than a duty cycle of the second differential signal, wherein the first processed signal is high once per clock period, generate the first processed signal representing a reference DC level when the duty cycle of the first differential signal is less than the duty cycle of the second differential signal, generate a second processed signal representing a difference between the second differential signal and the first differential signal when the duty cycle of the second differential signal is greater than the duty cycle of the first differential signal, wherein the second processed signal is high once per clock period, and generate the second processed signal representing the reference DC level when the duty cycle of the second differential signal is less than the duty cycle of the first differential signal. The class D amplifier may further comprise first and second output stages coupled to the signal processing block and configured to generate first and second output signals respectively based upon the first and second processed signals. The signal processing block may comprise: first and second inverters to configured receive the first and second differential signals and to output inverted versions of the first and second differential signals; a first AND gate configured to generate the first processed signal as having a first logic level based upon the first differential signal and the inverted version of the second differential signal having the first logic level; and a second AND gate configured to generate the second processed signal as having a first logic level based upon the second differential signal and the inverted version of the first differential signal having the first logic level. The second differential signal may be a complement of the first differential signal.

A method aspect is directed to a method of amplifying an analog audio signal. The method includes receiving a first analog signal, the first analog signal being the analog signal. The method also includes receiving a second analog signal, the second analog signal being a complement of the analog signal. The first and second analog input signals are converted into first and second square waves. A first processed signal representing a difference between the first square wave and the second square wave is generated when a duty cycle of the first square wave is greater than a duty cycle of the second square wave, wherein the first processed signal is high once per clock period. The first processed signal is generated as a reference DC level when the duty cycle of the first square wave is less than the duty cycle of the second square wave. A second processed signal representing a difference between the second square wave and the first square wave is generated when the duty cycle of the second square wave is greater than the duty cycle of the first square wave, wherein the second processed signal is high once per clock period. The second processed signal is generated as the reference DC level when the duty cycle of the second square wave is less than the duty cycle of the first square wave, and first and second output signals are respectively generated based upon the first and second processed signals, using respective first and second output stages. The first analog input signal may be converted into the first square wave by comparing the first analog input signal to a triangle wave. The second analog input signal may be converted into a second square wave by comparing the second analog input signal to a triangle wave. The first analog input signal may be converted into the first square wave by comparing the first analog input signal to a sawtooth wave. The second analog input signal may be converted into a second square wave by comparing the second analog input signal to the sawtooth wave. The second analog input signal may be a complement of the first analog input signal. According to a further aspect there is provided an electronic device, comprising: first and second comparators configured to respectively convert first and second analog audio input signals into first and second audio square waves; a logic block coupled to receive the first and second audio square waves from the first and second comparators and configured to: generate a first processed audio signal having a pulse representing twice a period of time from a rising edge of the first audio square wave to a rising edge of the second audio square wave when a duty cycle of the first audio square wave is greater than a duty cycle of the second audio square wave, generate the first processed audio signal having a reference DC level when the duty cycle of the first audio square wave is less than the duty cycle of the second audio square wave, generate a second processed audio signal having a pulse representing twice a period of time from a rising edge of the second audio square wave to a rising edge of the first audio square wave when the duty cycle of the second audio square wave is greater than the duty cycle of the first audio square wave, and generate the second processed audio signal having the reference DC level when the duty cycle of the second audio square wave is less than the duty cycle of the first audio square wave; and first and second output stages coupled to the logic block and configured to generate first and second audio output signals respectively based upon the first and second processed audio signals. The first comparator may be configured to convert the first analog audio input signal into a first audio square wave by comparing the first analog audio input signal to a triangle wave. The second comparator may be configured to convert the second analog audio input signal into a second audio square wave by comparing the second analog audio input signal to a triangle wave. The first output stage may comprise: a first amplifier configured to receive the first processed audio signal and to generate a first amplified audio signal, a first PMOS transistor having a source coupled to a supply voltage, a drain, and a gate to receive the first amplified audio signal, and a first NMOS transistor having a source coupled to ground, a drain coupled to the drain of the first PMOS transistor, and a gate to receive the first amplified audio signal, wherein the first PMOS transistor and first NMOS transistor cooperate to generate the first audio output signal; and wherein the second output stage comprises: a second amplifier configured to receive the second processed audio signal and to generate a second amplified audio signal, a second PMOS transistor having a source coupled to a supply voltage, a drain, and a gate to receive the second amplified audio signal, and a second NMOS transistor having a source coupled to ground, a drain coupled to the drain of the second PMOS transistor, and a gate to receive the second amplified audio signal, wherein the second PMOS transistor and second NMOS transistor cooperate to generate the second audio output signal. According to a further aspect there is provided an electronic device, comprising: first and second comparators configured to respectively convert first and second analog audio input signals into first and second audio square waves by comparing the first and second analog audio input signals to first and second waves having a reference period such that the first and second analog audio input signals each transition twice during the reference period; a logic block coupled to receive the first and second audio square waves from the first and second comparators and configured to generate first and second processed audio signals based upon the first and second audio square waves, only one of the first and second processed audio signals transitioning twice during the reference period; first and second output stages coupled to the logic block and configured to generate first and second audio output signals respectively based upon the first and second processed audio signals.

### BRIEF DESCRIPTION OF THE DRAWINGS

FIG. 1 is a schematic diagram of a class D amplifier in accordance with this disclosure.
FIG. 2 is a timing diagram of the class D amplifier of FIG. 1 in operation where the signal generator is a sawtooth wave generator.
FIG. 3 is a schematic diagram of an embodiment of the logic block of the class D amplifier of FIG. 1 where the signal generator is a sawtooth wave generator.
FIG. 4 is a flowchart of operation of the class D amplifier of FIG. 1 where the signal generator is a triangle wave generator.
FIG. 5 is a timing diagram of the class D amplifier of FIG. 1 in operation where the signal generator is a triangle waver generator.

### DETAILED DESCRIPTION

One or more embodiments will be described below. These described embodiments are only examples of implementation techniques, as defined solely by the attached claims. Additionally, in an effort to provide a focused description, irrelevant features of an actual implementation may not be described in the specification.

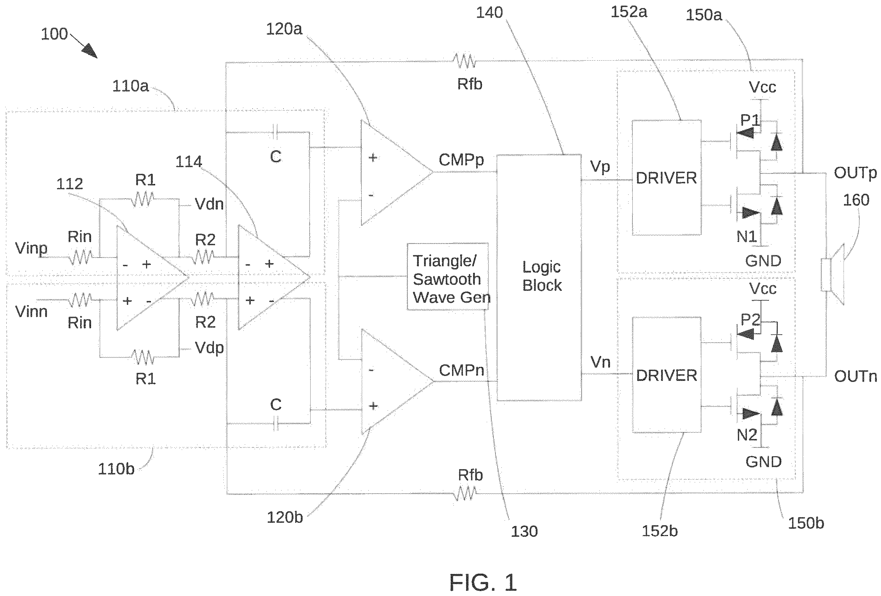

With reference to FIG. 1, a class D amplifier 100 having a bridge tied load 160 is now described. First, the structure of the class D amplifier 100 will be described, and then operation thereof will be described.

The class D amplifier 100 includes a first analog audio input channel 110a and a second analog audio input channel 110b. The first and second analog audio input channels 110a, 110b both include the same fully differential amplifier 112. The fully differential amplifier 112 includes input resistors Rin and feedback resistors R1, which set the gain. The outputs of the fully differential amplifier 112 feed into another fully differential amplifier 114, which has input resistors R2 and feedback capacitors C. The non-inverting output of the fully differential amplifier 114 is fed to the non-inverting input of a comparator 120a, while the inverting output of the fully differential amplifier 114 is fed to the non-inverting input of a comparator 120b. A signal generator 130 is coupled to the inverting inputs of both the comparator 120a and a comparator 120b.

The outputs of the comparator 120a and the comparator 120b are fed to a logic block 140, which has outputs fed to the output stage 150a and the output stage 150b. The output stage 150a includes a driver 152a having an input coupled to an output of the logic block 140. The output stage 150a also includes a first PMOS transistor P1 and a first NMOS transistor N1. The first PMOS transistor P1 has its source coupled to a power supply Vcc, and its gate coupled to a first output of the driver 152a. A diode D1 is coupled between the source and drain of the first PMOS transistor P1. The first NMOS transistor N1 has its source coupled to the drain of the first PMOS transistor P1, its drain coupled to ground GND, and its gate coupled to a second output of the driver 152a. A diode D2 is coupled between the source and drain of the first NMOS transistor N1.

The output stage 150b includes a driver 152b having an input coupled to an output of the logic block 140. The output stage 150b also includes a second PMOS transistor P2 and a second NMOS transistor N2. The second PMOS transistor P2 has its source coupled to the power supply Vcc, and its gate coupled to a first output of the driver 152b. A diode D3 is coupled between the source and drain of the second PMOS transistor P2. The second NMOS transistor N2 has its source coupled to the drain of the second PMOS transistor P2, its drain coupled to ground GND, and its gate coupled to a second output of the driver 152b. A diode D4 is coupled between the source and drain of the second NMOS transistor N2.

A load 160 has a first input coupled to the drain of the first PMOS transistor P1 and source of the first NMOS transistor N1, and has a second input coupled to the drain of the second PMOS transistor P2 and source of the second NMOS transistor N2. Resistors Rfb are coupled between the load 160 and inputs of the fully differential amplifier 114. The load 160 may, for example, comprise an analog speaker.

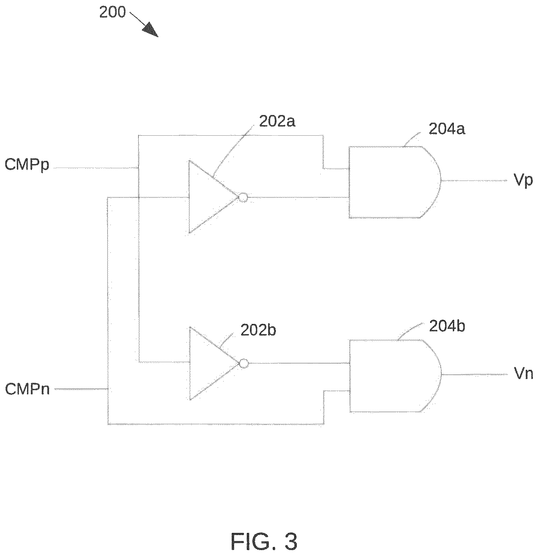

With reference to FIG. 3, structure of the logic block 140 will now be described. The logic block 140 includes a first inverter 202a, which has an input coupled to the output CMPp of the comparator 120b and an output coupled to a first input of the AND gate 204a. The AND gate 204a has a second input coupled to the output of the comparator 120a, and an output Vp coupled to the first output stage 150a.

The logic block 140 also includes a second inverter 202b, which has an input coupled to the output CMPn of the comparator 120a and an output coupled to a first input of the AND gate 204b. The AND gate 204b has a second input coupled to the output of the comparator 120b, and an output Vn coupled to the second output stage 150b.

Operation of the class D amplifier 100 will now be described with reference to FIGS. 1-3. The inputs of the fully differential amplifier 112 respectively receive first and second analog audio input signals. The fully differential amplifier 112 rejects common mode noise in the first and second analog audio input signals, and outputs the first and second analog audio input signals as first and second differential signals, with the common mode noise removed, to the fully differential amplifier 114, which serves to remove an unwanted DC offset from the first and second analog audio input signals. In some applications, the first and second analog audio input signals may be separate single input signals and not differential signals, as will be appreciated by those of skill in the art.

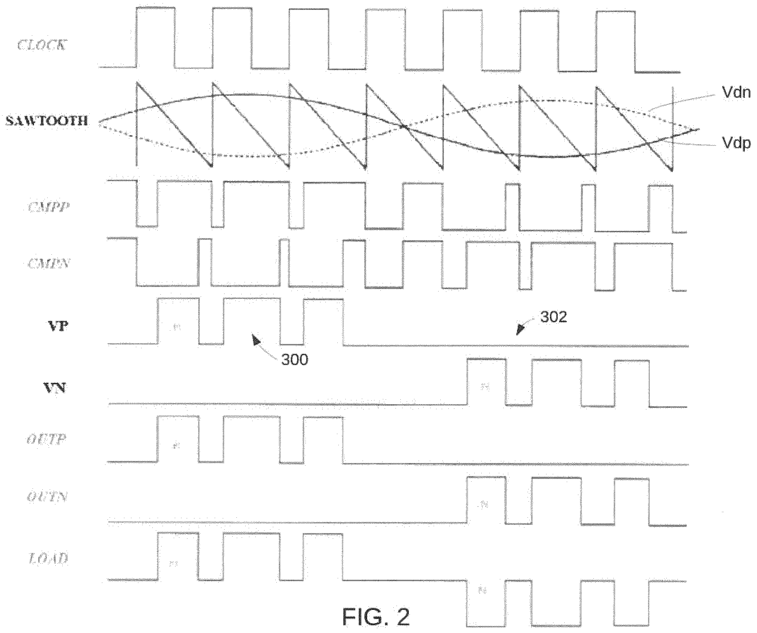

The first analog audio output signal Vdn is then fed from the fully differential amplifier 114 to the comparator 120a, which compares the first analog audio input signal to a sawtooth wave generated by the signal source or wave generator 130. This results in the generation of a first audio square wave CMPp having a duty cycle proportional to the amplitude of the first analog audio input signal. The first analog audio input signal and wave generated by the wave generator 130 are shown in FIG. 2 next to the label SAWTOOTH, while the first audio square wave is shown next to the label CMPP.

Similarly, the second audio output signal Vdp is fed from the fully differential amplifier 114 to the comparator 120b, which also compared the second analog audio input signal to the triangle or sawtooth wave generated by the wave generator 130. This also results in the generation of a second audio square wave CMPn having a duty cycle proportional to the amplitude of the second analog audio input signal. The second audio square wave is shown next to the label CMPN in FIG. 2.

The logic block 140 receives the first audio square wave and generates a first processed audio signal Vp therefrom. The logic block 140 generates the first processed audio signal Vp by its AND gate 204a performing a logic AND operation on the first audio square wave and an inverse of the second audio square wave. When the duty cycle of the first audio square wave is greater than the duty cycle (reference 300) of the second audio square wave, the first processed audio signal thus represents a difference between the first audio square wave and second audio square wave. When the duty cycle of the first audio square wave is less than the duty cycle of the second audio square wave (reference 302), the first processed audio signal thus represents a reference DC level or common mode voltage.

The logic block 140 also generates a second processed audio signal Vn from the second audio square wave. The logic block 140 generates the second processed audio signal Vn by its AND gate 204b performing a logic AND operation on the second audio square wave and an inverse of the first audio square wave. When the duty cycle of the second audio square wave is greater than the duty cycle of the first audio square wave (reference 302), the second processed audio signal thus represents a difference between the second audio square wave and the first audio square wave. When the duty cycle of the second audio square wave is less than the duty cycle of the first audio square wave (reference 300), the second processed audio signal Vn thus represents the reference DC level or the common mode voltage.

As shown by viewing the first and second processed audio signals Vp, Vn, the first and second processed audio signals are not high at the same time, and merely one of the audio signals is high during a single period of the triangle or sawtooth wave, and that audio signal is high but once during that single period. Thus, either P1 and N1 switch during a single period, or P2 and N2 switch during that single period, but not both pairs of transistors.

With conventional class D amplifiers, the first and second processed audio signals may be high at the same time. Thus, in conventional class D amplifiers, the transistors P1, N1 and P2, N2 will all switch twice during a single period of the triangle or sawtooth wave. The class D amplifier 100 disclosed herein thus reduces the amount of switching by 50% over conventional designs, resulting in greatly reduced EMI.

The driver 152a receives the first processed audio signal and amplifies it. When the first processed audio signal Vp is at a logic high, the first NMOS transistor N1 turns off, and the first PMOS transistor P1 turns on and generates the first audio output signal OUTp as high. When the first processed audio signal Vp is at a logic low, first PMOS transistor P1 turns off, and the first NMOS transistor N1 turns on and pulls the first audio output signal OUTp low.

The driver 152b likewise receives the second processed audio signal and drives the power MOS devices P2, N2. When the second processed audio signal Vn is at a logic high, the second NMOS transistor N2 turns off, and the second PMOS transistor P1 turns on and generates the second audio output signal OUTn as high. When the second processed audio signal Vn is at a logic low, the second PMOS transistor P2 turns off, and the second NMOS transistor N2 turns on and pulls the second audio output signal low OUTn.

The first audio output signal OUTp pulls the signal at the load, labeled LOAD in FIG. 2, high. On the other hand, the second audio output signal OUTn pulls the signal at the load, labeled LOAD in FIG. 2, negative. The signal at the load represents a difference between the first and second audio output signals OUTp, OUTn. Thus, if the first and second audio output signals OUTp, OUTn are high at the same time as is possible with conventional class D amplifiers and lack an overlapping transition, the signal at the load will transition four times for a given time period. However, as shown in FIG. 2, as a result of the operations performed by the logic block 140, the first and second audio output signals OUTp, OUTn would not be high at a same time. Thus, the signal at the load will transition but two times for the same given time period, as opposed to four times as in conventional systems. This halving of the number of transitions of the signal at the load.

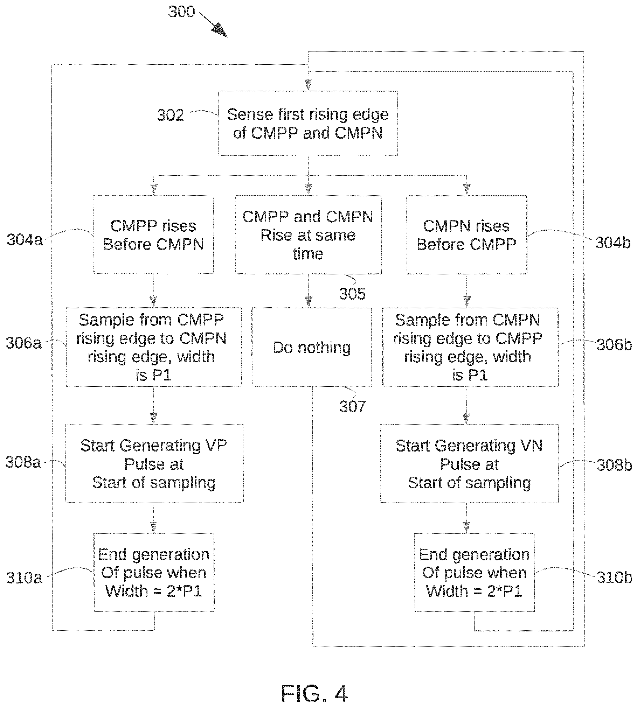

It should be appreciated that the wave generator 130 may generate a triangle wave instead of a sawtooth wave. This may result in CMPp and CMPn, output by comparators 120a and 120b, having no simultaneous transitions. In this case, the logic block 140 generates Vp and Vn as will now be described with reference to the flowchart 300 of FIGS. 4-5.

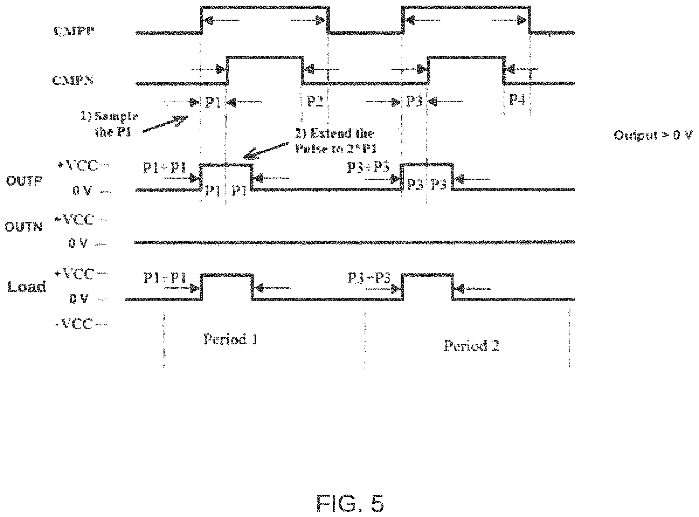

Due to the differential amplifier 112, Vdp and Vdn are fully differential output signals, and the frequency of the triangle wave is higher than the frequency of the analog audio input signal. Therefore, the width of P1 is equal to the width of P2, and the width of P3 is equal to the width of P4 in FIG. 5.

The logic block 140 monitors both CMPp and CMPn to sense a first rising edge (Block 302). If CMPp has a rising edge before CMPn (Block 304a), then the logic block 140 samples from the rising edge of CMPp to the rising edge of CMPn (Block 306a). This is shown in the timing diagram of FIG. 5, and this period of time is referred to as P1. The logic block 140 starts outputting Vp as high at the start of the sampling (Block 308a), and transitions Vp to low at an elapsed time of 2^{∗}P1 (Block 310a), as also shown in FIG. 5. The logic block 140 then returns to monitoring both CMPp and CMPn (Block 302). The load ultimately receives the output signal as 2^{∗}P1=P1+P2=CMPP-CMPN.

If CMPn had the first rising edge before CMPp (Block 304b), then the logic block 140 samples from the rising edge of CMPn to the rising edge of CMPp (Block 306b). The logic block 140 starts outputting Vn as high at the start of the sampling (Block 308b), and thereafter transitions Vn to low at an elapsed time equal to double the length of time from the rising edge of CMPn to the rising edge of CMPp (Block 310b). The logic block 140 then returns to monitoring both CMPp and CMPn (Block 302).

In the case where CMPp and CMPn rise at the same time (Block 305), the logic block 140 takes no action, leaving Vp and Vn as low (Block 307), and continues to monitor both CMPp and CMPn (Block 302).

While the disclosure has been described with respect to a limited number of embodiments, those skilled in the art, having benefit of this disclosure, will appreciate that other embodiments can be envisioned that do not depart from the scope of the disclosure as disclosed herein. Accordingly, the scope of the disclosure shall be limited only by the attached claims.

## Claims

1. An electronic device, comprising:
first and second comparators (120a, 120b) configured to respectively convert first and second analog audio input signals into first and second audio square waves by comparing, respectively, the first and second analog audio input signals with a triangle or sawtooth wave generated by a signal generator (130), wherein the second analog audio input signal is a complement of the first analog audio input signal;
a class D amplifier (100) coupled to receive the first and second audio square waves from the first and second comparators (120a, 120b),
**characterised in that** the class D amplifier (100), comprises:
a logic block (140), the logic block (140) comprising:
first and second inverters (202a, 202b) configured to receive the second and first audio square waves and to output inverted versions of the second and first audio square waves, respectively;
a first AND gate (204a) configured to:
generate a first processed audio signal representing a difference between the first audio square wave and the inverse of the second audio square wave, if a duty cycle of the first audio square wave is greater than a duty cycle of the second audio square wave, wherein the first processed audio signal is high once per clock period of the triangle or sawtooth wave,
generate the first processed audio signal representing a reference DC level, if the duty cycle of the first audio square wave is less than the duty cycle of the second audio square wave; and
a second AND gate (204b) configured to:
generate a second processed audio signal representing a difference between the second audio square wave and the inverse of the first audio square wave, if the duty cycle of the second audio square wave is greater than the duty cycle of the first audio square wave, wherein the second processed audio signal is high once per clock period of the triangle or sawtooth wave, and
generate the second processed audio signal representing the reference DC level, if the duty cycle of the second audio square wave is less than the duty cycle of the first audio square wave; and
first and second output stages (150a, 150b), coupled to receive the first and second processed audio signals respectively from the logic block (140), and configured to generate first and second output signals respectively based upon the first and second processed audio signals, wherein the first and second output signals are not high at the same time and are high once per clock period of the triangle or sawtooth wave;
wherein the logic block (140) is configured to:
generate the first processed audio signal having a pulse representing twice a period of time from a rising edge of the first audio square wave to a rising edge of the second audio square wave if a duty cycle of the first audio square wave is greater than a duty cycle of the second audio square wave; and
wherein the logic block (140) is configured to:
generate the second processed audio signal having a pulse representing twice a period of time from a rising edge of the second audio square wave to a rising edge of the first audio square wave if the duty cycle of the second audio square wave is greater than the duty cycle of the first audio square wave.

2. The electronic device of claim 1, wherein the second audio square wave is a complement of the first audio square wave.

3. The electronic device of claim 1, wherein the first comparator (120a) is configured to convert the first analog audio input signal into the first audio square wave by comparing the first analog audio input signal to the triangle wave; and wherein the second comparator (120b) is configured to convert the second analog audio input signal into the second audio square wave by comparing the second analog audio input signal to the triangle wave.

4. The electronic device of claim 1, wherein the first comparator (120a) is configured to convert the first analog audio input signal into the first audio square wave by comparing the first analog audio input signal to the sawtooth wave; and wherein the second comparator (120b) is configured to convert the second analog audio input signal into the second audio square wave by comparing the second analog audio input signal to the sawtooth wave.

5. The electronic device of claim 1,
wherein the first output stage (150a) comprises:
a first amplifier (152a) configured to receive the first processed audio signal and to generate a first amplified audio signal,
a first PMOS transistor having a source coupled to a supply voltage, a drain, and a gate to receive the first amplified audio signal, and
a first NMOS transistor having a source coupled to ground, a drain coupled to the drain of the first PMOS transistor, and a gate to receive the first amplified audio signal,
wherein the first PMOS transistor and first NMOS transistor cooperate to generate the first audio output signal;
and wherein the second output stage comprises:
a second amplifier (152b) configured to receive the second processed audio signal and to generate a second amplified audio signal,
a second PMOS transistor having a source coupled to a supply voltage, a drain, and a gate to receive the second amplified audio signal, and
a second NMOS transistor having a source coupled to ground, a drain coupled to the drain of the second PMOS transistor, and a gate to receive the second amplified audio signal,
wherein the second PMOS transistor and second NMOS transistor cooperate to generate the second audio output signal.

6. The electronic device of claim 5, further comprising a load (160) coupled to receive the first and second audio output signals.

7. The electronic device of claim 1, wherein the second analog audio input signal is an inverse of the first analog audio input signal; and wherein the first and second analog audio input signals are audio square waves.

8. A method of amplifying an analog audio signal, comprising:
receiving a first analog audio input signal, the first analog audio input signal being the analog audio signal;
receiving a second analog audio input signal, the second analog audio input signal being a complement of the analog audio signal;
converting the first and second analog audio input signals, with respective first and second comparators (120a, 120b), into first and second audio square waves by comparing, respectively, the first and second analog audio input signals with a triangle or sawtooth wave generated by a signal generator (130), wherein the second analog audio input signal is a complement of the first analog audio input signal;
amplifying, with a class-D amplifier (100), the first and second audio square waves received from the first and second comparators (120a, 120b);
inverting, with a first and second inverter of the class-D amplifier (100), the second and first audio square waves to generate inverted versions of the second and first audio square waves, respectively;
**characterised in** generating, with a first AND gate (204a) of a logic block (140), a first processed audio signal representing a difference between the first square wave and the inverse of the second square wave and having a pulse representing twice a period of time from a rising edge of the first audio square wave to a rising edge of the second audio square wave, if a duty cycle of the first square wave is greater than a duty cycle of the second square wave, wherein the first processed audio signal is high once per clock period of the triangle or sawtooth wave;
generating the first processed audio signal as a reference DC level, if the duty cycle of the first square wave is less than the duty cycle of the second square wave;
generating, with a second AND gate (204b) of the logic block (140), a second processed audio signal representing a difference between the second square wave and the first square wave and having a pulse representing twice a period of time from a rising edge of the second audio square wave to a rising edge of the first audio square wave, if the duty cycle of the second square wave is greater than the duty cycle of the first square wave, wherein the second processed audio signal is high once per clock period of the triangle or sawtooth wave;
generating the second processed audio signal as the reference DC level, if the duty cycle of the second square wave is less than the duty cycle of the first square wave;
generating first and second output signals respectively based upon the first and second processed signals, using respective first and second output stages (150a, 150b), wherein the first and second output signals are not high at the same time and are high once per clock period of the triangle or sawtooth wave;
generating, with the first AND gate (204a), the first processed audio signal having a pulse representing twice a period of time from a rising edge of the first audio square wave to a rising edge of the second audio square wave if a duty cycle of the first audio square wave is greater than a duty cycle of the second audio square wave; and
generating, with the second AND gate (204b), the second processed audio signal having a pulse representing twice a period of time from a rising edge of the second audio square wave to a rising edge of the first audio square wave if the duty cycle of the second audio square wave is greater than the duty cycle of the first audio square wave.

9. The method of claim 8, wherein the first analog audio input signal is converted into the first audio square wave by comparing the first analog audio input signal to the triangle wave; and wherein the second analog audio input signal is converted into the second audio square wave by comparing the second analog audio input signal to the triangle wave.

10. The method of claim 8, wherein the first analog audio input signal is converted into the first audio square wave by comparing the first analog audio input signal to the sawtooth wave; and wherein the second analog audio input signal is converted into the second audio square wave by comparing the second analog audio input signal to the sawtooth wave.

## Patentansprüche

1. Elektronische Vorrichtung, umfassend:
einen ersten und einen zweiten Komparator (120a, 120b), die dazu konfiguriert sind, ein erstes bzw. ein zweites analoges Audioeingangssignal durch Vergleichen des ersten bzw. des zweiten analogen Audioeingangssignals mit einer Dreieck- oder Sägezahnwelle, die von einem Signalgenerator (130) erzeugt wird, in eine erste bzw. eine zweite Audiorechteckwelle umzuwandeln, wobei das zweite analoge Audioeingangssignal ein Komplement des ersten analogen Audioeingangssignals ist;
einen Klasse-D-Verstärker (100), der gekoppelt ist, um die erste und die zweite Audiorechteckwelle von dem ersten und dem zweiten Komparator (120a, 120b) zu empfangen,
**dadurch gekennzeichnet, dass** der Klasse-D-Verstärker (100) umfasst:
einen Logikblock (140), wobei der Logikblock (140) umfasst:
einen ersten und einen zweiten Inverter (202a, 202b), die dazu konfiguriert sind, die zweite und die erste Audiorechteckwelle zu empfangen und invertierte Versionen der zweiten bzw. der ersten Audiorechteckwelle auszugeben;
ein erstes UND-Gatter (204a), das konfiguriert ist zum:
Erzeugen eines ersten verarbeiteten Audiosignals, das eine Differenz zwischen der ersten Audiorechteckwelle und der Inverse der zweiten Audiorechteckwelle darstellt, wenn ein Tastverhältnis der ersten Audiorechteckwelle höher als ein Tastverhältnis der zweiten Audiorechteckwelle ist, wobei das erste verarbeitete Audiosignal einmal pro Taktperiode der Dreieck- oder Sägezahnwelle hoch ist,
Erzeugen des ersten verarbeiteten Audiosignals, das einen Referenz-DC-Pegel darstellt, wenn das Tastverhältnis der ersten Audiorechteckwelle niedriger als das Tastverhältnis der zweiten Audiorechteckwelle ist; und
ein zweites UND-Gatter (204b), das konfiguriert ist zum:
Erzeugen eines zweiten verarbeiteten Audiosignals, das eine Differenz zwischen der zweiten Audiorechteckwelle und der Inverse der ersten Audiorechteckwelle darstellt, wenn das Tastverhältnis der zweiten Audiorechteckwelle höher als das Tastverhältnis der ersten Audiorechteckwelle ist, wobei das zweite verarbeitete Audiosignal einmal pro Taktperiode der Dreieck- oder Sägezahnwelle hoch ist, und
Erzeugen des zweiten verarbeiteten Audiosignals, das den Referenz-DC-Pegel darstellt, wenn das Tastverhältnis der zweiten Audiorechteckwelle niedriger als das Tastverhältnis der ersten Audiorechteckwelle ist; und
eine erste und eine zweite Ausgangsstufe (150a, 150b), die gekoppelt sind, um das erste bzw. das zweite verarbeitete Audiosignal von dem Logikblock (140) zu empfangen, und dazu konfiguriert sind, ein erstes bzw. ein zweites Ausgangssignal auf der Basis des ersten und des zweiten verarbeiteten Audiosignals zu erzeugen, wobei das erste und das zweite Audiosignal nicht gleichzeitig hoch sind und einmal pro Taktperiode der Dreieck- oder Sägezahnwelle hoch sind;
wobei der Logikblock (140) konfiguriert ist zum:
Erzeugen des ersten verarbeiteten Audiosignals mit einem Impuls, der das Doppelte eines Zeitraums von einer steigenden Flanke der ersten Audiorechteckwelle zu einer steigenden Flanke der zweiten Audiorechteckwelle darstellt, wenn ein Tastverhältnis der ersten Audiorechteckwelle höher als ein Tastverhältnis der zweiten Audiorechteckwelle ist; und
wobei der Logikblock (140) konfiguriert ist zum:
Erzeugen des zweiten verarbeiteten Audiosignals mit einem Impuls, der das Doppelte eines Zeitraums von einer steigenden Flanke der zweiten Audiorechteckwelle zu einer steigenden Flanke der ersten Audiorechteckwelle darstellt, wenn das Tastverhältnis der zweiten Audiorechteckwelle höher als das Tastverhältnis der ersten Audiorechteckwelle ist.

2. Elektronische Vorrichtung nach Anspruch 1, wobei die zweite Audiorechteckwelle ein Komplement der ersten Audiorechteckwelle ist.

3. Elektronische Vorrichtung nach Anspruch 1, wobei der erste Komparator (120a) dazu konfiguriert ist, das erste analoge Audioeingangssignal durch Vergleichen des ersten analogen Audioeingangssignals mit der Dreieckwelle in die erste Audiorechteckwelle umzuwandeln; und der zweite Komparator (120b) dazu konfiguriert ist, das zweite analoge Audioeingangssignal durch Vergleichen des zweiten analogen Audioeingangssignals mit der Dreieckwelle in die zweite Audiorechteckwelle umzuwandeln.

4. Elektronische Vorrichtung nach Anspruch 1, wobei der erste Komparator (120a) dazu konfiguriert ist, das erste analoge Audioeingangssignal durch Vergleichen des ersten analogen Audioeingangssignals mit der Sägezahnwelle in die erste Audiorechteckwelle umzuwandeln; und der zweite Komparator (120b) dazu konfiguriert ist, das zweite analoge Audioeingangssignal durch Vergleichen des zweiten analogen Audioeingangssignals mit der Sägezahnwelle in die zweite Audiorechteckwelle umzuwandeln.

5. Elektronische Vorrichtung nach Anspruch 1,
wobei die erste Ausgangsstufe (150a) umfasst:
einen ersten Verstärker (152a), der dazu konfiguriert ist, das erste verarbeitete Audiosignal zu empfangen und ein erstes verstärktes Audiosignal zu erzeugen,
einen ersten PMOS-Transistor mit einer Source, die an eine Versorgungsspannung gekoppelt ist, einem Drain und einem Gatter, um das erste verstärkte Audiosignal zu empfangen, und
einen ersten NMOS-Transistor mit einer Source, die an Masse gekoppelt ist, einem Drain, der an den Drain des ersten PMOS-Transistors gekoppelt ist, und einem Gatter, um das erste verstärkte Audiosignal zu empfangen,
wobei der erste PMOS-Transistor und der erste NMOS-Transistor zusammenwirken, um das erste Ausgangssignal zu erzeugen;
und wobei die zweite Ausgangsstufe umfasst:
einen ersten Verstärker (152b), der dazu konfiguriert ist, das zweite verarbeitete Audiosignal zu empfangen und ein zweites verstärktes Audiosignal zu erzeugen,
einen zweiten PMOS-Transistor mit einer Source, die an eine Versorgungsspannung gekoppelt ist, einem Drain und einem Gatter, um das zweite verstärkte Audiosignal zu empfangen, und
einen zweiten NMOS-Transistor mit einer Source, die an Masse gekoppelt ist, einem Drain, der an den Drain des zweiten PMOS-Transistors gekoppelt ist, und einem Gatter, um das zweite verstärkte Audiosignal zu empfangen,
wobei der zweite PMOS-Transistor und der zweite NMOS-Transistor zusammenwirken, um das zweite Ausgangssignal zu erzeugen.

6. Elektronische Vorrichtung nach Anspruch 5, weiterhin umfassend eine Last (160), die gekoppelt ist, um das erste und das zweite Audioausgangssignal zu empfangen.

7. Elektronische Vorrichtung nach Anspruch 1, wobei das zweite analoge Audioeingangssignal eine Inverse des ersten analogen Audioeingangssignals ist und wobei das erste und das zweite analoge Audioeingangssignal Audiorechteckwellen sind.

8. Verfahren zur Verstärkung eines analogen Audiosignals, umfassend:
Empfangen eines ersten analogen Audioeingangssignals, wobei das erste analoge Audioeingangssignal das analoge Audiosignal ist;
Empfangen eines zweiten analogen Audioeingangssignals, wobei das zweite analoge Audioeingangssignal ein Komplement des analogen Audiosignals ist;
Umwandeln des ersten und des zweiten analogen Audioeingangssignals mit einem ersten bzw. einem zweiten Komparator (120a, 120b) durch Vergleichen des ersten bzw. des zweiten analogen Audioeingangssignals mit einer Dreieck- oder Sägezahnwelle, die von einem Signalgenerator (130) erzeugt wird, in eine erste und eine zweite Audiorechteckwelle, wobei das zweite analoge Audioeingangssignal ein Komplement des ersten analogen Audioeingangssignals ist;
Verstärken der ersten und der zweiten Audiorechteckwelle, die von dem ersten und dem zweiten Komparator (120a, 120b) empfangen werden, mit einem Klasse-D-Verstärker (100);
Invertieren der zweiten und der ersten Audiorechteckwelle mit einem ersten und einem zweiten Inverter des Klasse-D-Verstärkers (100), um invertierte Versionen der zweiten bzw. der ersten Audiorechteckwelle zu erzeugen;
**gekennzeichnet durch** Erzeugen eines ersten verarbeiteten Audiosignals, das eine Differenz zwischen der ersten Rechteckwelle und der Inverse der zweiten Rechteckwelle darstellt und einen Impuls aufweist, der das Doppelte eines Zeitraums von einer steigenden Flanke der ersten Audiorechteckwelle zu einer steigenden Flanke der zweiten Audiorechteckwelle darstellt, mit einem ersten UND-Gatter (204a) eines Logikblocks (140), wenn ein Tastverhältnis der ersten Rechteckwelle höher als ein Tastverhältnis der zweiten Rechteckwelle ist, wobei das erste verarbeitete Audiosignal einmal pro Taktperiode der Dreieck- oder Sägezahnwelle hoch ist;
Erzeugen des ersten verarbeiteten Audiosignals als einen Referenz-DC-Pegel, wenn das Tastverhältnis der ersten Rechteckwelle niedriger als das Tastverhältnis der zweiten Rechteckwelle ist;
Erzeugen eines zweiten verarbeiteten Audiosignals, das eine Differenz zwischen der zweiten Rechteckwelle und der ersten Rechteckwelle darstellt und einen Impuls aufweist, der das Doppelte eines Zeitraums von einer steigenden Flanke der zweiten Audiorechteckwelle zu einer steigenden Flanke der ersten Audiorechteckwelle darstellt, mit einem zweiten UND-Gatter (204b) des Logikblocks (140), wenn das Tastverhältnis der zweiten Rechteckwelle höher als das Tastverhältnis der ersten Rechteckwelle ist, wobei das zweite verarbeitete Audiosignal einmal pro Taktperiode der Dreieck- oder Sägezahnwelle hoch ist;
Erzeugen des zweiten verarbeiteten Audiosignals als den Referenz-DC-Pegel, wenn das Tastverhältnis der zweiten Rechteckwelle niedriger als das Tastverhältnis der ersten Rechteckwelle ist;
Erzeugen eines ersten bzw. eines zweiten Ausgangssignals auf der Basis des ersten und des zweiten verarbeiteten Signals unter Verwendung einer ersten bzw. einer zweiten Ausgangsstufe (150a, 150b), wobei das erste und das zweite Audiosignal nicht gleichzeitig hoch sind und einmal pro Taktperiode der Dreieck- oder Sägezahnwelle hoch sind;
Erzeugen des ersten verarbeiteten Audiosignals mit einem Impuls, der das Doppelte eines Zeitraums von einer steigenden Flanke der ersten Audiorechteckwelle zu einer steigenden Flanke der zweiten Audiorechteckwelle darstellt, mit dem ersten UND-Gatter (204a), wenn ein Tastverhältnis der ersten Audiorechteckwelle höher als ein Tastverhältnis der zweiten Audiorechteckwelle ist; und
Erzeugen des zweiten verarbeiteten Audiosignals mit einem Impuls, der das Doppelte eines Zeitraums von einer steigenden Flanke der zweiten Audiorechteckwelle zu einer steigenden Flanke der ersten Audiorechteckwelle darstellt, mit dem zweiten UND-Gatter (204b), wenn ein Tastverhältnis der zweiten Audiorechteckwelle höher als ein Tastverhältnis der ersten Audiorechteckwelle ist.

9. Verfahren nach Anspruch 8, wobei das erste analoge Audioeingangssignal durch Vergleichen des ersten analogen Audioeingangssignals mit der Dreieckwelle in die erste Audiorechteckwelle umgewandelt wird; und wobei das zweite analoge Audioeingangssignal durch Vergleichen des zweiten analogen Audioeingangssignals mit der Dreieckwelle in die zweite Audiorechteckwelle umgewandelt wird.

10. Verfahren nach Anspruch 8, wobei das erste analoge Audioeingangssignal durch Vergleichen des ersten analogen Audioeingangssignals mit der Sägezahnwelle in die erste Audiorechteckwelle umgewandelt wird; und wobei das zweite analoge Audioeingangssignal durch Vergleichen des zweiten analogen Audioeingangssignals mit der Sägezahnwelle in die zweite Audiorechteckwelle umgewandelt wird.

## Revendications

1. Dispositif électronique, comportant :
des premier et deuxième comparateurs (120a, 120b) configurés pour convertir respectivement des premier et deuxième signaux d'entrée audio analogiques en des première et deuxième ondes carrées audio en comparant, respectivement, les premier et deuxième signaux d'entrée audio analogiques par rapport à une onde triangulaire ou en dents de scie générée par un générateur de signaux (130), dans lequel le deuxième signal d'entrée audio analogique est un complément du premier signal d'entrée audio analogique ;
un amplificateur de classe D (100) couplé pour recevoir les première et deuxième ondes carrées audio en provenance des premier et deuxième comparateurs (120a, 120b),
**caractérisé en ce que** l'amplificateur de classe D (100) comporte :
un bloc logique (140), le bloc logique (140) comportant :
des premier et deuxième inverseurs (202a, 202b) configurés pour recevoir les deuxième et première ondes carrées audio et pour émettre en sortie des versions inversées des deuxième et première ondes carrées audio, respectivement ;
une première porte ET (204a) configurée pour :
générer un premier signal audio traité représentant une différence entre la première onde carrée audio et l'inverse de la deuxième onde carrée audio, si un facteur d'utilisation de la première onde carrée audio est supérieur à un facteur d'utilisation de la deuxième onde carrée audio, dans lequel le premier signal audio traité est haut une fois par période d'horloge de l'onde triangulaire ou en dents de scie,
générer le premier signal audio traité représentant un niveau DC (duty cycle - facteur d'utilisation) de référence, si le facteur d'utilisation de la première onde carrée audio est inférieur au facteur d'utilisation de la deuxième onde carrée audio ; et
une deuxième porte ET (204b) configurée pour :
générer un deuxième signal audio traité représentant une différence entre la deuxième onde carrée audio et l'inverse de la première onde carrée audio, si le facteur d'utilisation de la deuxième onde carrée audio est supérieur au facteur d'utilisation de la première onde carrée audio, dans lequel le deuxième signal audio traité est haut une fois par période d'horloge de l'onde triangulaire ou en dents de scie, et
générer le deuxième signal audio traité représentant un niveau DC de référence, si le facteur d'utilisation de la deuxième onde carrée audio est inférieur au facteur d'utilisation de la première onde carrée audio ; et
des premier et deuxième étages de sortie (150a, 150b) couplés pour recevoir les premier et deuxième signaux audio traités respectivement en provenance du bloc logique (140), et configurés pour générer des premier et deuxième signaux de sortie basés respectivement sur les premier et deuxième signaux audio traités, dans lequel les premier et deuxième signaux de sortie ne sont pas hauts en même temps et sont hauts une fois par période d'horloge de l'onde triangulaire ou en dents de scie ;
dans lequel le bloc logique (140) est configuré pour :
générer le premier signal audio traité ayant une impulsion représentant deux fois une période de temps depuis un front montant de la première onde carrée audio jusqu'à un front montant de la deuxième onde carrée audio si un facteur d'utilisation de la première onde carrée audio est supérieur à un facteur d'utilisation de la deuxième onde carrée audio ; et
dans lequel le bloc logique (140) est configuré pour :
générer le deuxième signal audio traité ayant une impulsion représentant deux fois une période de temps depuis un front montant de la deuxième onde carrée audio jusqu'à un front montant de la première onde carrée audio si le facteur d'utilisation de la deuxième onde carrée audio est supérieur au facteur d'utilisation de la première onde carrée audio.

2. Dispositif électronique selon la revendication 1, dans lequel la deuxième onde carrée audio est un complément de la première onde carrée audio.

3. Dispositif électronique selon la revendication 1, dans lequel le premier comparateur (120a) est configuré pour convertir le premier signal d'entrée audio analogique en la première onde carrée audio en comparant le premier signal d'entrée audio analogique par rapport à l'onde triangulaire ; et dans lequel le deuxième comparateur (120b) est configuré pour convertir le deuxième signal d'entrée audio analogique en la deuxième onde carrée audio en comparant le deuxième signal d'entrée audio analogique par rapport à l'onde triangulaire.

4. Dispositif électronique selon la revendication 1, dans lequel le premier comparateur (120a) est configuré pour convertir le premier signal d'entrée audio analogique en la première onde carrée audio en comparant le premier signal d'entrée audio analogique par rapport à l'onde en dents de scie ; et dans lequel le deuxième comparateur (120b) est configuré pour convertir le deuxième signal d'entrée audio analogique en la deuxième onde carrée audio en comparant le deuxième signal d'entrée audio analogique par rapport à l'onde en dents de scie.

5. Dispositif électronique selon la revendication 1,
dans lequel le premier étage de sortie (150a) comporte :
un premier amplificateur (152a) configuré pour recevoir le premier signal audio traité et pour générer un premier signal audio amplifié,
un premier transistor MOS à canal P ayant une source couplée à une tension d'alimentation, un drain, et une gâchette pour recevoir le premier signal audio amplifié, et
un premier transistor MOS à canal N ayant une source couplée à la terre, un drain couplé au drain du premier transistor MOS à canal P, et une gâchette pour recevoir le premier signal audio amplifié,
dans lequel le premier transistor MOS à canal P et le premier transistor MOS à canal N coopèrent pour générer le premier signal de sortie audio ;
et dans lequel le deuxième étage de sortie comporte :
un deuxième amplificateur (152b) configuré pour recevoir le deuxième signal audio traité et pour générer un deuxième signal audio amplifié,
un deuxième transistor MOS à canal P ayant une source couplée à une tension d'alimentation, un drain, et une gâchette pour recevoir le deuxième signal audio amplifié, et
un deuxième transistor MOS à canal N ayant une source couplée à la terre, un drain couplé au drain du deuxième transistor MOS à canal P, et une gâchette pour recevoir le deuxième signal audio amplifié,
dans lequel le deuxième transistor MOS à canal P et le deuxième transistor MOS à canal N coopèrent pour générer le deuxième signal de sortie audio.

6. Dispositif électronique selon la revendication 5, comportant par ailleurs une charge (160) couplée pour recevoir les premier et deuxième signaux de sortie audio.

7. Dispositif électronique selon la revendication 1, dans lequel le deuxième signal d'entrée audio analogique est un inverse du premier signal d'entrée audio analogique ; et dans lequel les premier et deuxième signaux d'entrée audio analogiques sont des ondes carrées audio.

8. Procédé d'amplification d'un signal audio analogique, comportant les étapes consistant à :
recevoir un premier signal d'entrée audio analogique, le premier signal d'entrée audio analogique étant le signal audio analogique ;
recevoir un deuxième signal d'entrée audio analogique, le deuxième signal d'entrée audio analogique étant un complément du signal audio analogique ;
convertir les premier et deuxième signaux d'entrée audio analogiques, au moyen de premier et deuxième comparateurs respectifs (120a, 120b), en des première et deuxième ondes carrées audio en comparant, respectivement, les premier et deuxième signaux d'entrée audio analogiques par rapport à une onde triangulaire ou en dents de scie générée par un générateur de signaux (130), dans lequel le deuxième signal d'entrée audio analogique est un complément du premier signal d'entrée audio analogique ;
amplifier, au moyen d'un amplificateur de classe D (100), les première et deuxième ondes carrées audio reçues en provenance des premier et deuxième comparateurs (120a, 120b) ;
inverser, au moyen d'un premier et deuxième inverseur de l'amplificateur de classe D (100), les deuxième et première ondes carrées audio pour générer des versions inversées des deuxième et première ondes carrées audio, respectivement ;
caractérisé en les étapes consistant à générer, au moyen d'une première porte ET (204a) d'un bloc logique (140), un premier signal audio traité représentant une différence entre la première onde carrée et l'inverse de la deuxième onde carrée et ayant une impulsion représentant deux fois une période de temps depuis un front montant de la première onde carrée audio jusqu'à un front montant de la deuxième onde carrée audio, si un facteur d'utilisation de la première onde carrée est supérieur à un facteur d'utilisation de la deuxième onde carrée, dans lequel le premier signal audio traité est haut une fois par période d'horloge de l'onde triangulaire ou en dents de scie ;
générer le premier signal audio traité sous la forme d'un niveau DC (duty cycle - facteur d'utilisation) de référence, si le facteur d'utilisation de la première onde carrée est inférieur au facteur d'utilisation de la deuxième onde carrée ;
générer, au moyen d'une deuxième porte ET (204b) du bloc logique (140), un deuxième signal audio traité représentant une différence entre la deuxième onde carrée et la première onde carrée et ayant une impulsion représentant deux fois une période de temps depuis un front montant de la deuxième onde carrée audio jusqu'à un front montant de la première onde carrée audio si le facteur d'utilisation de la deuxième onde carrée est supérieur au facteur d'utilisation de la première onde carrée, dans lequel le deuxième signal audio traité est haut une fois par période d'horloge de l'onde triangulaire ou en dents de scie ;
générer le deuxième signal audio traité sous la forme du niveau DC de référence, si le facteur d'utilisation de la deuxième onde carrée est inférieur au facteur d'utilisation de la première onde carrée ;
générer des premier et deuxième signaux de sortie basés respectivement sur les premier et deuxième signaux traités, en utilisant des premier et deuxième étages de sortie respectifs (150a, 150b), dans lequel les premier et deuxième signaux de sortie ne sont pas hauts en même temps et sont hauts une fois par période d'horloge de l'onde triangulaire ou en dents de scie ;
générer, au moyen de la première porte ET (204a), le premier signal audio traité ayant une impulsion représentant deux fois une période de temps depuis un front montant de la première onde carrée audio jusqu'à un front montant de la deuxième onde carrée audio si un facteur d'utilisation de la première onde carrée audio est supérieur à un facteur d'utilisation de la deuxième onde carrée audio ; et
générer, au moyen de la deuxième porte ET (204b), le deuxième signal audio traité ayant une impulsion représentant deux fois une période de temps depuis un front montant de la deuxième onde carrée audio jusqu'à un front montant de la première onde carrée audio si le facteur d'utilisation de la deuxième onde carrée audio est supérieur au facteur d'utilisation de la première onde carrée audio.

9. Procédé selon la revendication 8, dans lequel le premier signal d'entrée audio analogique est converti en la première onde carrée audio en comparant le premier signal d'entrée audio analogique par rapport à l'onde triangulaire ; et dans lequel le deuxième signal d'entrée audio analogique est converti en la deuxième onde carrée audio en comparant le deuxième signal d'entrée audio analogique par rapport à l'onde triangulaire.

10. Procédé selon la revendication 8, dans lequel le premier signal d'entrée audio analogique est converti en la première onde carrée audio en comparant le premier signal d'entrée audio analogique par rapport à l'onde en dents de scie ; et dans lequel le deuxième signal d'entrée audio analogique est converti en la deuxième onde carrée audio en comparant le deuxième signal d'entrée audio analogique par rapport à l'onde en dents de scie.
